# EUROPEAN PATENT SPECIFICATION

(11) **EP 0 396 123 B1**
(45) Date of publication and mention of the grant of the patent: **07.01.1998**
(21) Application number: 90108335.2
(22) Date of filing: 02.05.1990
(51) Int. Cl.: H03H 7/01

(54) **Parallel connection multi-stage band-pass filter**
Bandpass-Filter mit mehreren parallel geschalteten Stufen
Filtre passe-bande à plusieurs étages reliés en parallèle

(30) Priority: 02.05.1989 JP 113927/89; 19.04.1990 JP 103961/90
(43) Date of publication of application: 07.11.1990
(73) Proprietor: MURATA MANUFACTURING CO., LTD., Nagaokakyo-shi Kyoto-fu 226 (JP)
(72) Inventor: Wakino, Kikuo, c/o Murata Manufacturing Co., Ltd., Nakaokakyo-shi, Kyoto-fu (JP); Nishikawa, Toshio, c/o Murata Manufact. Co., Ltd., Nakaokakyo-shi, Kyoto-fu (JP); Ishikawa, Youhei, c/o Murata Manufact. Co., Ltd., Nakaokakyo-shi, Kyoto-fu (JP); Takehara, Koichi, c/o Murata Manufact. Co., Ltd., Nakaokakyo-shi, Kyoto-fu (JP); Tanizaki, Toru, c/o Murata Manufact. Co., Ltd., Nakaokakyo-shi, Kyoto-fu (JP)
(74) Representative: Glawe, Delfs, Moll & Partner

(56) References cited:
- GB-A- 1 062 269
- US-A- 2 709 206
- US-A- 2 716 733
- US-A- 3 345 589
- TECH NOTES, NASA TECH BRIEF, no. 3, July 1974, Washington, US; GODDARD SPACE FLIGHT CENTER: "High Q band-pass resonators utilizing composite band-stop resonator pairs"
- SOVIET INVENTIONS ILLUSTRATED, week 8721, 3rd June 1987, section El, class W, page 10, abstract no. 87-149698/21, Derwent Publications Ltd, London, GB; & SU- A-1262 601 (KUSLIK) 07-10-1986
- PATENT ABSTRACTS OF JAPAN, vol. 12, no. 101 (E-595), 2nd April 1988; & JP-A-62 233 910

## Description

### BACKGROUND OF THE INVENTION

The present invention generally relates to an electrical filter, and more particularly, to a parallel connection multi-stage band-pass filter suitable for use as a channel filter of a radio frequency signal combining/sorting device for a mobile unit communication system such as an automobile telephone and the like, or as a transmission/receiving filter for a mobile equipment, etc.

It has been a recent trend that, in a mobile unit communication system such as an automobile telephone, etc., a so-called cellular system is widely employed, while, due to a rapid increase in the number of users, it is required to reduce the cell radius and also, to increase the number of base stations. Following such a tendency, compact size, low loss and cost reduction are required also for the radio frequency signal combining/sorting device to be employed in the base station.

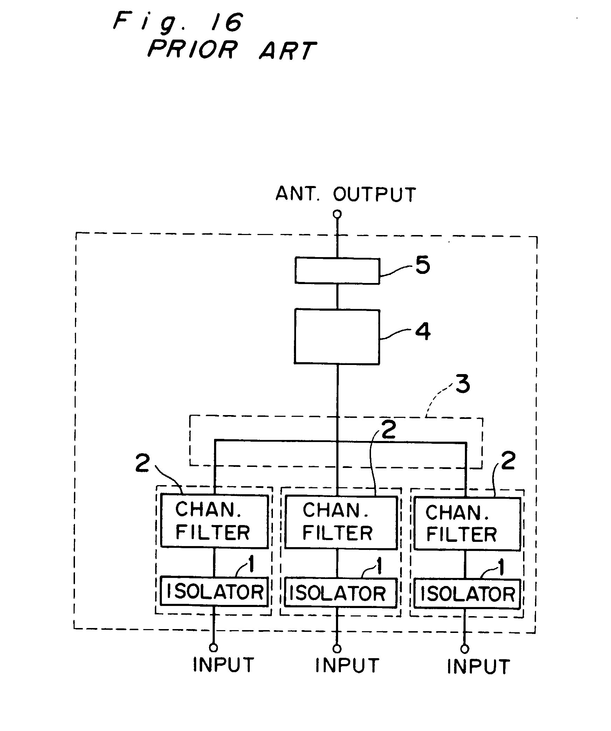

As shown in Fig. 16, the radio frequency signal combining/sorting device to be used for the base station of the cellular system, includes a plurality of sets of isolators 1 and channel filters 2, a power composition net work 3 for composing these sets of insulators 1 and channel filters 2, an antenna monitor 4, and one antenna filter 5 coupled to each other as shown.

In a conventional radio frequency signal combining/sorting device of the above described type, the filter used as the channel filter 2 is constituted by band-pass filters (abbreviated as BPF) which allow signals of frequency band possessed by respective channels to pass therethrough.

Incidentally, the known band-pass filter of the above described type is designed by a practice as described hereinbelow, thereby to realize a filter for actual applications.

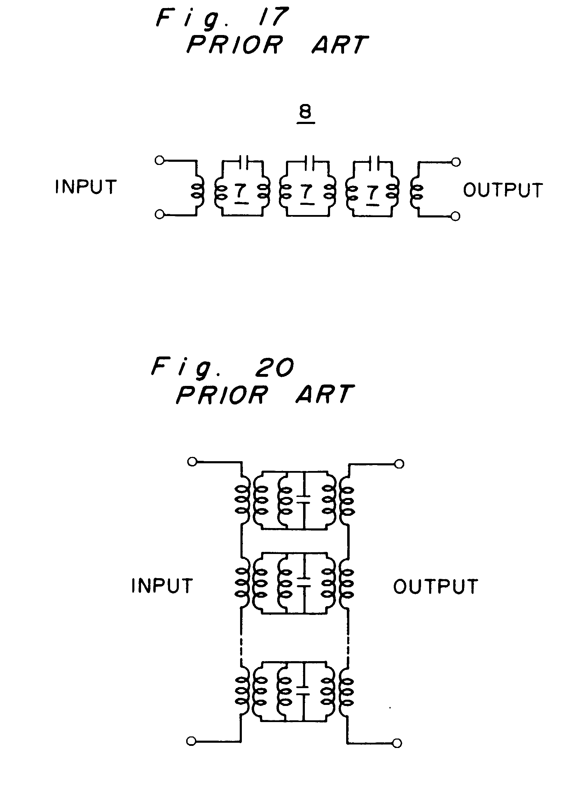

More specifically, the design circuit for the band-pass filter as described above is obtained by subjecting a low-pass filter (abbreviated as LPF) for which a generally known designing theory is present, to circuit conversion by a conversion formula called an inverter. The band-pass filter circuit thus obtained by such circuit conversion is of a series connection multi-stage band-pass filter circuits in which neighboring LC resonance circuits 7 of a plurality of LC resonance circuits are sequentially subjected to induction coupling to each other as shown in Fig. 17.

The series connection multi-stage band-pass filter circuit 8 of Fig. 17 as referred to above is the so-called design circuit for designing the band-pass filter, and is characterized in that it is readily realized in a microwave band region.

For realizing the series connection multi-stage band-pass filter circuit 8 which is the design circuit obtained in the above described manner as an actual filter, the respective LC resonance circuits 7 in three stages connected in series to each other as in Fig. 17 are replaced or approximated by actual resonators, for example, TE_{01δ} dielectric resonators. By such a practice, the series connection multi-stage band-pass filter including the plurality of dielectric resonators and having given frequency characteristics are realized.

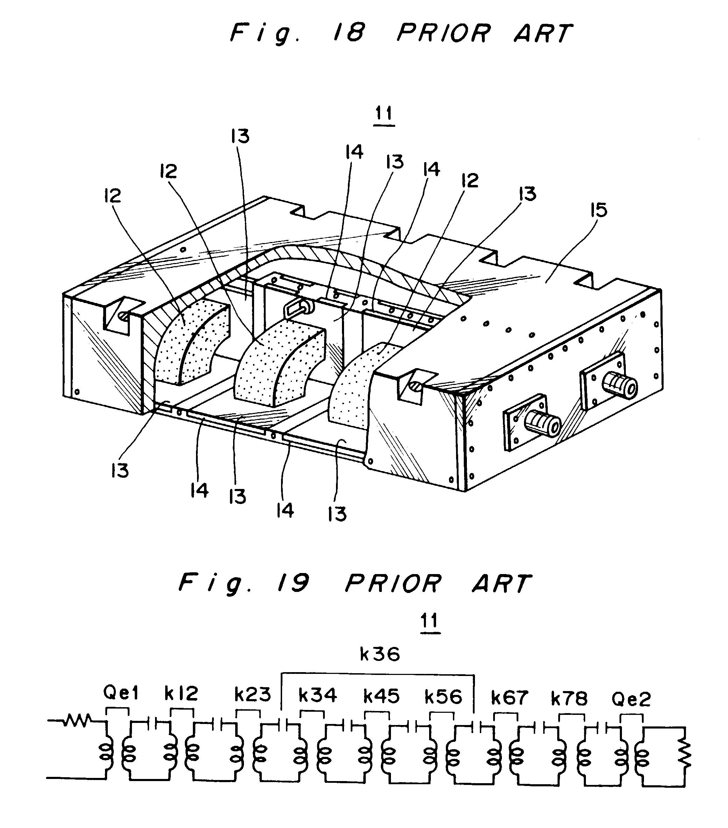

One example of the series connection multi-stage band-pass filter 11 thus realized is illustrated in Fig. 18, with its equivalent circuit given in Fig. 19.

The series connection multi-stage band-pass filter 11 as referred to above is the filter proposed by the present inventors as "Dielectric high-power band-pass filter using quarter-cut TE_{01δ} image resonator for cellular stations" on pages 1150 to 1155, of IEEE transactions on microwave theory and techniques, MTT, Vol-35, No. 12, December 1987, and as shown in Fig. 18, includes a plurality of arcuate dielectric resonators 12 referred to as "quarter-cut TE_{01δ} image resonator" by the present inventors, and each formed by 1/4 portion of the TE_{01δ} mode dielectric resonator originally in an annular shape, and ceramic substrates 14 formed with electrode films on surfaces 13 thereof and disposed in an L-shape to act as an electric wall, with said arcuate dielectric resonators 12 being fixed on said ceramic substrates 14 through predetermined intervals. These ceramic substrates 14 and dielectric resonators 12 function as the TE_{01δ} mode image resonators. The ceramic substrates 14 referred to above are electrically and mechanically fixed onto walls of a metallic housing 15, whereby the interior of the above housing 15 is to have the construction equivalent to the TE_{01δ} mode circular cut-off type waveguide divided into 1/4. The dielectric resonators 12 are respectively subjected to induction coupling to each other, with the dielectric resonators 12 as the respective ends being coupled with external loads through induction.

Incidentally, although the series connection multi-stage band-pass filter 11 as described above may be reduced in its size to a large extent as compared with a filter employing the ordinary cavity resonator, due to the fact that the series-coupled resonators of this kind is generally so arranged that respective natural vibration modes take care of the respective frequency components, with the dielectric resonators 12 being connected in series, energy distribution is different according to the dielectric resonators 12 at respective stages.

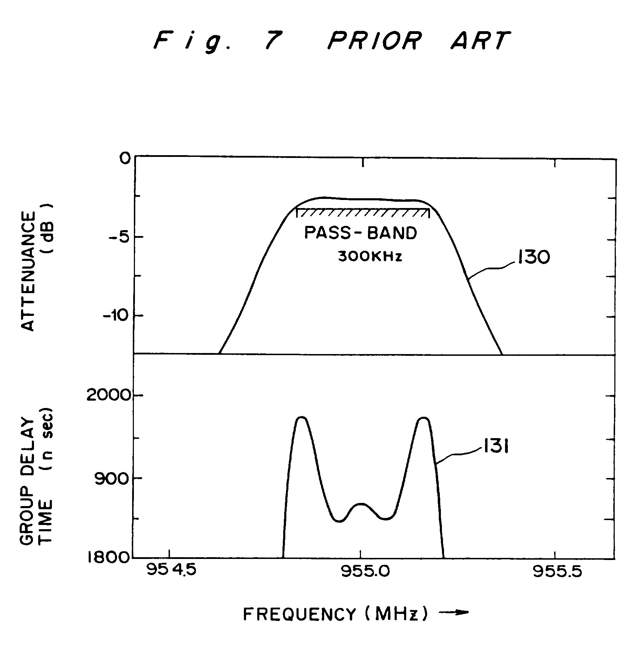

Fig. 7 shows one example of band-pass characteristic and group delay characteristic to be obtained by the conventional three stage series connection multi-stage band-pass filter.

As is seen from the above group delay characteristic, in the series connection multi-stage band-pass filter, it is difficult to realize flat group delay characteristic over the entire pass-band region, because due to the fact that the respective frequency components are shared by the respective natural vibration modes, external coupling degrees for all natural vibration modes are correlatively altered even if parameters for the resonators are adjusted, and thus, group delay characteristic at the respective resonance frequencies can not be set as desired.

Moreover, the group delay characteristic of the series connection multi-stage band-pass filter is characterized in that it has peak values at opposite ends of the pass-band region, and in order to obtain the flat group delay characteristic over the entire working band region to be used, it is required to broaden the design region so that the peaks at the opposite ends are located outside the working band region, thus making it difficult to realize band-pass characteristics sufficiently superior in selectivity.

Furthermore, the group delay characteristic as described above can not fully cope with the digitalization of transmission signals rapidly advancing at present, and realization of filters having flat group delay characteristic has been strongly demanded.

Incidentally, the filter realized in the manner as described above is, after all, approximation of the design circuit of the band-pass filter derived based on the design theory of the low-pass filter, by the TE_{01δ} mode dielectric resonator 12, and does not have the characteristics fully in agreement with the design characteristics possessed by the design circuit referred to earlier.

Therefore, there has been proposed by Zuiho KYO et al., a parallel-coupled circuit simulation model utilizing an inherent mode developing method for making it possible to effect simulation of the series-coupled filter realized as described above, on pages 9 to 16 of a paper entitled "Composition of microwave circuit by inherent mode developing method" (Electronic communication institute, microwave research meeting data, MW82-54, 1982).

The parallel-coupled circuit simulation model referred to above has the circuit construction as shown in Fig. 20, and is intended to make it possible to realize simulation including asymmetrical nature of attenuation, and spurious of a microwave filter.

In the case where a series connection multi-stage band-pass filter has natural vibration modes of m pieces, it is assumed, in this model, that the respective variation modes are realized, for example, by continuous resonators in n=3 pieces, and therefore, the natural vibration modes of m pieces are to be obtained by the multi-stage resonators of (m x n) pieces on the whole. In the above case, it should be noted here that, for example, in the case where the relation is n=3, since mutual coupling of the three resonators connected by series coupling takes place, the degree of -freedom of the respective natural vibration modes becomes 7, while the degree of freedom of the electrical characteristic on the assumption that each resonator is independent, is naturally 9.

Although the above simulation model is extremely useful for analysis of the natural vibration mode of a series connection multi-stage band-pass filter, this is a practice in a theoretical analysis after all, and said model can not be used as it is for an actual filter.

Tech notes, Nasa tech brief, No. 3, July 1974, Washington US; Goddard Flight Center: "A high Q Band-pass resonators utilizing composite band-stop resonator pairs" discloses a parallel connection multi-stage band-pass filter comprising an input terminal and an output terminal for signals, and a plurality of resonators respectively having resonance frequency different from and close to each other, and electrically connected in parallel relation to each other between the input and output terminals.

Additionally, a parallel connection multi-stage-band-pass filter according to the precharacterizing part of claim 1 is disclosed in US-A-2709206. In this document the coupling between the impedance matching means and the resonators is performed directly. The filter of this document is intended for a frequency region of several tens Hz. In this case the corresponding wavelength is very large compared with the dimension of the filter. Therefore, coupling between the resonators will not occur.

### SUMMARY OF THE INVENTION

Accordingly, an essential object of the present invention is to provide a multi-stage band-pass filter which is capable of realizing a flat group delay characteristic over an entire pass band region.

Another object of the present invention is to provide a multi-stage band-pass filter of the above described type which can readily obtain necessary electrical characteristic.

A further object of the present invention is to provide a multi-stage band-pass filter of the above described type in which the electrical characteristic of each resonator may be contributed to the electrical characteristic of the filter as it is.

The present inventors regarded part of the above simulation circuit, e.g. a reference vibration mode portion as a new filter circuit, and in order to materialized the design circuit, constituted the parallel connection multi-stage band-pass filter by substituting respective LC resonance circuits of the above simulation circuit by actual resonators, e.g. TE _{01δ} mode dielectric or transmission lines resonators, and thus, found that said parallel connection multi-stage band-pass filter can readily flatten the group delay characteristic in the specific pass-band region.

In accomplishing these and other objects, according to preferred embodiments of the present invention, there are provided parallel connection multi-stage band-pass filters having features as stated in claim 1. The further claims are related to advantageous aspects of the invention.

In an aspect of the present invention, the parallel connection multi-stage band-pass filter includes an input terminal and an output terminal, for signals and a plurality of resonators each provided with first and second ports and having frequencies different from and close to each other. Said first port of each of said resonators is electrically connected to said input terminal through a first impedance matching means, and said second port of each of said resonators is electrically connected to said output terminal through a second impedance matching means.

In a second aspect of the present invention, in the parallel connection multi-stage band-pass filter as stated above, the first port of each of said resonators is electrically connected to said input terminal through said first impedance matching means by induction coupling, with the second port of each of said resonators being electrically connected to said output terminal through said second impedance matching means by induction coupling.

In a third aspect of the present invention, in the parallel connection multi-stage band-pass filter as stated above, the first port of each of said resonators is electrically connected to said input terminal through said first impedance matching means by capacity coupling, with the second port of each of said resonators being electrically connected to said output terminal through said second impedance matching means by capacity coupling.

In a fourth aspect of the present invention, in the parallel connection multi-stage band-pass filter as stated above, the respective resonators are of dielectric resonators.

In a fifth aspect of the present invention, in the parallel connection multi-stage band-pass filter as stated above, the respective resonators are of transmission line type resonators.

In a sixth aspect of the present invention, in the parallel connection multi-stage band-pass filter as stated above, said transmission line type resonators are of coaxial dielectric resonators or micro-strip lines.

In a seventh aspect of the present invention, in the parallel connection multi-stage band-pass filter as stated above of said respective resonators, in which three resonators are provided the resonators respectively having the maximum and minimum resonance frequencies have approximately the same load Q, whereby the remaining resonator having an intermediate frequency has a load Q approximately the same as or smaller than said approximately the same load Q.

In an eighth aspect of the present invention, in the parallel connection multi-stage band-pass filter as stated above, the load Q of each of said resonators is so set that the amount of variation of positive direction transfer function of said band-pass filter within a predetermined pass-band region becomes small when a non-load Q of each of said resonators is finite.

In a ninth aspect of the present invention, in the parallel connection multi-stage band-pass filter as stated above, the load Q of each of said resonators is so set that respective amounts of variation at a plurality of variation points, to be produced in the frequency characteristic of group delay time within a predetermined pass-band region of said band-pass filter become approximately equal to each other.

In a tenth aspect of the present invention, in the parallel connection multi-stage band-pass filter as stated above, the load Q of each of said resonators is so set that respective amounts of variation at a plurality of variation points, to be produced in the frequency characteristic of group delay time within a predetermined pass-band region of said band-pass filter become approximately zero.

In an eleventh aspect of the present invention, in the parallel connection multi-stage band-pass filter as stated above, phases in the respective resonance frequencies of the respective signals passing through the resonators having neighboring resonance frequencies are inverted to each other.

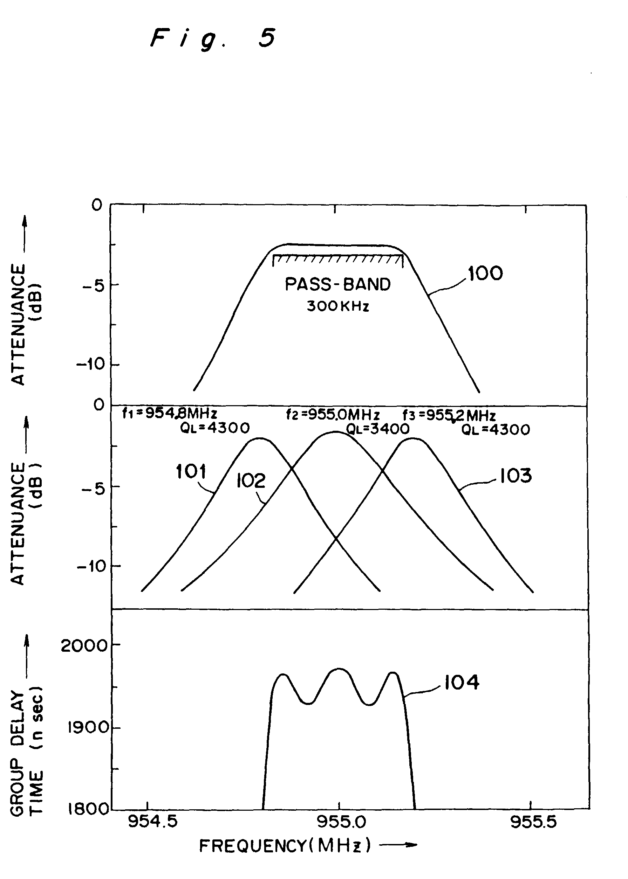

In a parallel connection multi-stage band-pass filter the electrical characteristics of the parallelly coupled individual resonators independently contribute to the electrical characteristics of the band-pass filter. In other words, n pieces of resonators constituting the band-pass filter can take care of the respectively corresponding frequency regions, and due to the above fact, frequency characteristic of flat positive direction transfer function and also, flat group delay time can be obtained (Fig. 5).

In the first aspect of the present invention, the respective resonators are electrically connected in parallel between the input and output terminals for the signals respectively through the first and second impedance matching means. By this arrangement, in addition to the favorable frequency characteristic as referred to above, the signal inputted and outputted at the input and output ends can be allowed to enter or come out of the band-pass filter in the impedance matched state.

Moreover, in the band-pass filter of the above second aspect, the first port of each of the resonators is electrically connected to the input end through the first impedance matching means by induction coupling or capacity coupling, while the second port of each resonator is electrically connected to said output end through the second impedance matching means by induction coupling or capacity coupling.

Meanwhile, in the above respective parallel connection multi-stage band-pass filter, the respective resonators should preferably be dielectric resonators, transmission line type resonators preferably of coaxial dielectric resonators, or micro-strip lines.

Moreover, by the arrangement for the load Q in the above eighth aspect, frequency characteristic for more flat positive direction transfer function and group delay time may be obtained.

Particularly, by setting the load Q of each resonator so that the variation amount of the positive direction transfer function within the predetermined pass-band region of said band-pass filter becomes small when the non-load Q of the resonator is infinite, extremely flat frequency characteristic of the positive direction transfer function may be obtained. Moreover, by setting the load Q of each resonator so that the respective variation amounts at a plurality of variation points produced in the frequency characteristic of the group delay time within the predetermined pass-band region become approximately equal to each other, favorable frequency characteristic of group delay time still more flat can be advantageously obtained. Furthermore, by setting the load Q of each resonator so that such variation amounts as referred to above become approximately zero, extremely flat frequency characteristic of the group delay time can be achieved.

Furthermore, by the arrangement for the phase inversion as in the above ninth aspect of the present invention in the frequency in the vicinity of an intermediate frequency of the two neighboring resonance frequencies, formation of the attenuation pole on the frequency characteristic of the positive direction transfer function may be prevented.

According to the present invention, since a plurality of resonators having resonance frequencies different from and close to each other are electrically connected in a parallel relation between the input end and the output end, with the frequency component of the signal being electrically divided into the respective resonators, energy distribution to be applied to each resonator becomes uniform, and thus, by adjusting the electrical characteristics of the respective resonators, the frequency characteristics for flat positive direction transfer function and also, for flat group delay characteristic may be obtained.

Moreover, since the respective resonators are electrically connected in parallel between the input and output ends respectively through the first and second impedance matching means, the frequency characteristics of the flat positive direction transfer function, and also, flat group delay time can be obtained, while the signal inputted and outputted at the input and output ends for the signals can be inputted or outputted with respect to the band-pass filter in the impedance matched state.

Furthermore, in the above parallel connection multi-stage band-pass filter, by arranging so that in said respective resonators, the resonators respectively having the maximum and minimum resonance frequencies have approximately the same load Q, with the other resonator having intermediate frequency having a load Q approximately the same as or smaller than said approximately the same load Q, frequency characteristics of still more flat positive direction transfer function, and more flat group delay characteristic may be advantageously achieved.

In addition, by the arrangement in which phases in the respective resonance frequencies of the respective signals passing through the resonators having neighboring resonance frequencies are inverted to each other, it becomes possible to prevent formation of attenuation pole on the frequency characteristics of the positive direction transfer function in the frequency in the vicinity of the intermediate frequency of the two neighboring resonance frequencies.

### BRIEF DESCRIPTION OF THE DRAWINGS

These and other objects and features of the present invention will become apparent from the following description taken in conjunction with the preferred embodiment thereof with reference to the accompanying drawings, in which;
Fig. 1 is a circuit diagram showing a fundamental circuit construction for an induction-coupled type parallel connection multi-stage band-pass filter,
Figs. 2(a) and 2(b) are respectively circuit diagrams showing examples of band-pass filters in which the fundamental circuit of Fig. 1 is realized in the microwave band region,
Figs. 3(a) and 3(b) are respectively explanatory sectional diagrams showing examples of parallel connection multi-stage band-pass filters in which the resonators in Figs. 2(a) and 2(b) are constituted by TE_{01δ} mode dielectric resonators,
Figs. 4(a) and 4(b) are respectively circuit diagrams showing equivalent circuits for the parallel connection multi-stage band-pass filters of Figs. 3(a) and 3(b),
Fig. 5 is a graphical diagram showing the frequency characteristic of attenuance and that of group delay time for the band-pass filter of Fig. 3(a),
Fig. 6 is also a graphical diagram showing the frequency characteristic of attenuance and that of group delay characteristic of the band-bass filters for the respective channels in the case where the band-pass filter of Fig. 3(a) is applied to three channels of a mobile communication system,
Fig. 7 is a graphical diagram showing the frequency characteristic of attenuance and that of group delay characteristic of a conventional series connection multi-stage band-pass filter,
Fig. 8 is also a graphical diagram showing the frequency characteristic of attenuance and that of group delay characteristic of the band pass filters for the respective channels in the case where the conventional multi-stage filter is applied to three channels of a mobile communication system,
Fig. 9 is a diagram showing comparison between the feature of the parallel connection multi-stage band-pass filter according to the present invention and that of the conventional series connection multi-stage band-pass filter,
Figs. 10(a), 10(b) and 10(c) are respectively a front sectional view, a top plan view and a side sectional view showing a modification of the band-pass filter of Fig. 3(a),
Fig. 11 is a circuit diagram showing a fundamental circuit of a capacity coupled type parallel connection multi-stage band-pass filter according to a second embodiment of the present invention,
Figs. 12(a) and 12(b) are respectively circuit diagrams showing examples of band-pass filters in which the fundamental circuit of Fig. 11 is realized in the microwave band region,
Fig. 13(a) is a schematic top plan view showing a parallel connection multi-stage band-pass filter in which the resonators in Figs. 12 are constituted by dielectric coaxial resonators,
Fig. 13(b) is a side elevational view of the band-pass filter of Fig. 13(a),
Fig. 14 is a perspective view showing the parallel connection multi-stage band-pass filter in which the resonators in Fig. 12(a) are constituted by micro-strip lines,
Fig. 15 is a graphical diagram showing the frequency characteristics for attenuance and that for group delay time for the band-pass filter of Fig. 12(a),
Fig. 16 is a block diagram of a radio frequency signal combining/sorting device to be used for a base station of the cellular system,
Fig. 17 is a circuit diagram of a band-pass filter (BPF) obtained by subjecting the low-pass filter (LPF) constituted by the generally known design theory, to circuit conversion by an inverting formula called an inverter,
Fig. 18 is a perspective view, partly broken away, of a conventional parallel connection multi-stage band-pass filter,
Fig. 19 is a circuit diagram showing an equivalent circuit of the series connection multi-stage band-pass filter of Fig. 18, and
Fig. 20 is a circuit diagram of a simulation model for the parallel coupled circuit of the conventional series connection multi-stage band-pass filter.

### DETAILED DESCRIPTION OF THE INVENTION

Before the description of the present invention proceeds, it is to be noted that like parts are designated by like reference numerals throughout the accompanying drawings.

Referring now to the drawings, embodiments according to the present invention will be described hereinafter.

A parallel connection multi-stage band-pass filter includes an input terminal or input end and an output terminal or output end for signals, and a plurality of resonators respectively having resonance frequencies different from and close to each other, and electrically connected in a parallel relation to each other between said input and output terminals.

In the above band-pass filter, the first embodiment discloses an arrangement in which the plurality of resonators are connected between the input and output terminals by induction coupling, while the second embodiment relates to an example in which said resonators are connected to said input and output terminals through capacity coupling.

### First embodiment

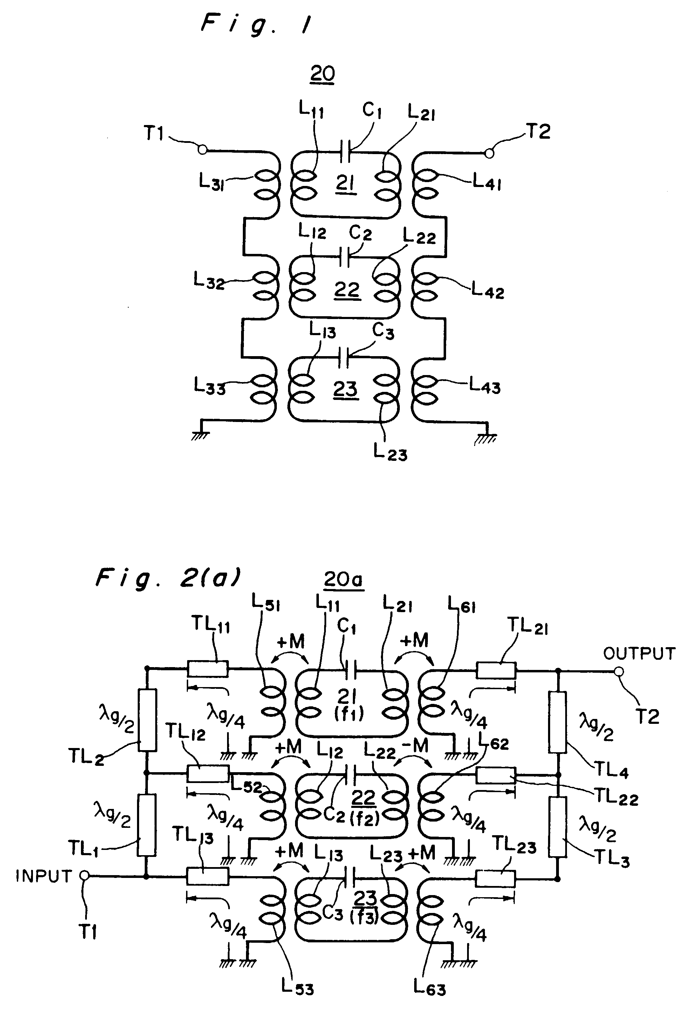

Fig. 1 shows a fundamental circuit construction 20 of an induction-coupled type parallel connection multi-stage band-pass filter.

In Fig. 1, an input terminal or input end T1 for the signal is connected to ground through three inductors or coils L31,L32,L33 connected in series to each other, while an output terminal or output end T2 for the signal is also connected to ground via three series-connected inductors L41,L42 and L43 as shown. Numerals 21,22 and 23 represent series resonance circuits for the resonators, and the circuit 21 includes two series-connected inductors 511 and L21 and a capacitor C1, and the circuit 22 is constituted by two series-connected inductors L12 and L22 and a capacitor C2, and the circuit 23 includes two series-connected inductors L13 and L23 and a capacitor C3.

Here, the inductors L31 and L11, the inductors L32 and L12, and the inductors L33 and L13 are respectively electrically connected by induction coupling. Similarly, the inductors L21 and L41, the inductors L22 and L42, and the inductors L23 and L43 are respectively electrically connected by induction coupling.

Moreover, the series resonance circuits 21,22 and 23 are arranged to have frequencies different from, but close to each other, and the respective resonance circuits 21,22 and 23 are constituted as band-pass filters having the above resonance frequencies as center frequencies for the pass-band. Accordingly, the parallel connection multi-stage band-pass filter shown in Fig. 1 has the pass-band in which the pass-bands of the above series connection resonance circuits 21,22 and 23 are piled one upon another.

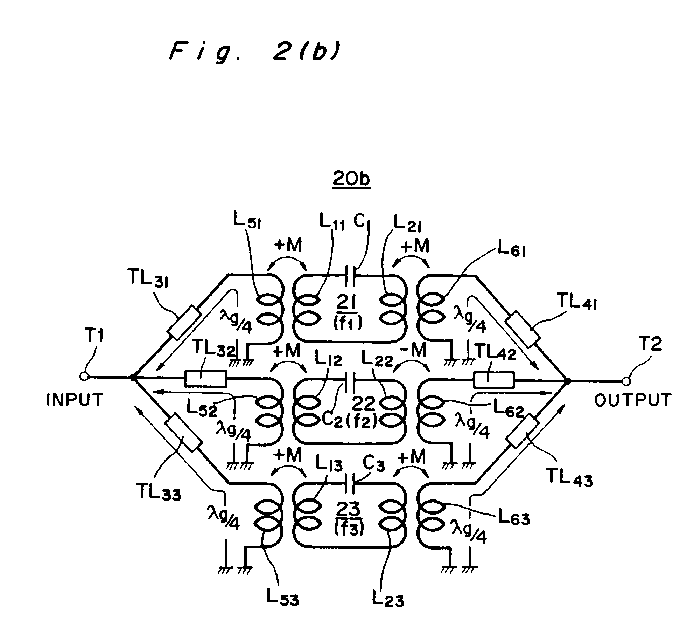

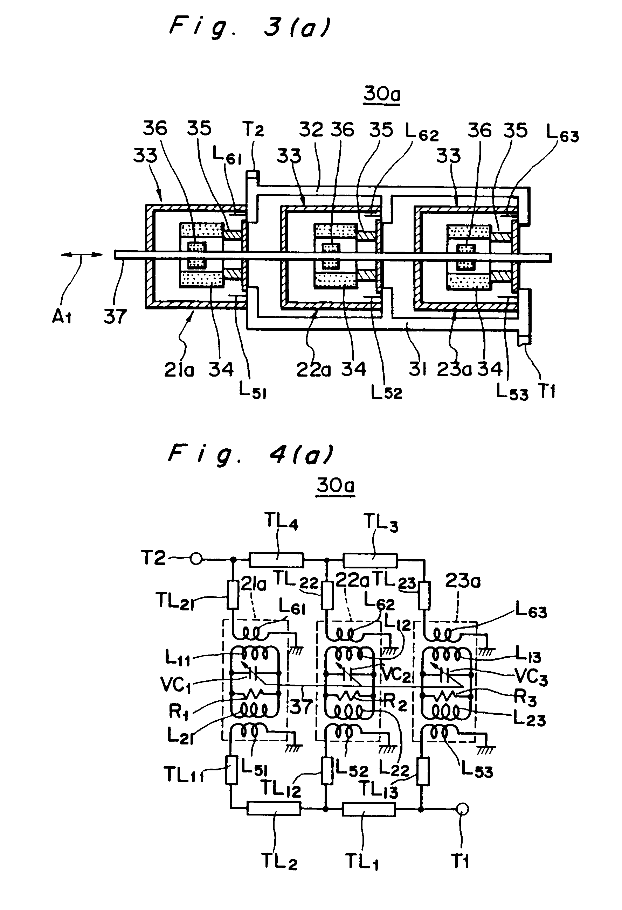

Fig. 2(a) shows a band-pass filter 20a in which the fundamental circuit 20 of Fig. 1 is realized in a microwave band region. In Fig. 2(a), like parts in Fig. 1 are designated by like reference numerals for brevity of explanation.

In the circuit of Fig. 2(a), the series resonance circuits 21,22 and 23 are constructed in the similar manner as in Fig. 1, respectively having resonance frequencies f1,f2,f3 (f1<f2<f3).

The input end T1 for the signal is connected to ground through transmission lines TL1 and TL2 each having an electrical length of λg/2, and a transmission line TL11 having a predetermined electrical length and an inductor L51, and also through a transmission line TL13 having a predetermined electrical length and an inductor L53. Meanwhile, a junction between the transmission lines TL1 and TL2 is connected to ground through another transmission line TL12 having a predetermined electrical length and an inductor L52. In the above arrangement, an electrical length from a connecting point at the side of line TL2 in the line TL11, to the ground shortcircuiting point through the inductor L51 is set at λg/4, an electrical length from a connecting point at the side of line TL1 in the line TL12, to the ground shortcircuiting point through the inductor L52 is set at λg/4, and an electrical length from a connecting point at the side of the input and T1 in the line TL13, to the ground shortcircuiting point through the inductor L53 is set at λg/4. It is to be noted here that λg represents propagation wavelength on the transmission line e.g. at the frequency f2 which is the center frequency of this band-pass filter.

On the other hand, the signal output end T2 is connected to the ground through a transmission line TL21 having a predetermined electrical length and an inductor L61, and also to the ground through transmission lines TL4 and TL3 respectively having electrical length of λg/2, and a transmission line TL23 having a predetermined electrical length and an inductor L63. Meanwhile, a junction between the transmission lines TL3 and TL4 is connected to ground through another transmission line TL22 having a predetermined electrical length and an inductor L62. In the above arrangement, an electrical length from a connecting point at the side of the output line T2 in the line TL21, to the ground shortcircuiting point through an inductor L61 is set at λg/4, an electrical length from a connecting point at the side of line TL4 in the line TL22, to the ground shortcircuiting point through an inductor L62 is set at λg/4, and an electrical length from a connecting point at the side of the line TL3 in the line TL23, to the ground shortcircuiting point through the inductor L63 is set at λg/4.

The above inductors L11 and L51 are electrically connected to each other through inductor coupling, at an induction coupling factor +M, the inductors L12 and L52, at an induction coupling factor +M, and the inductors L13 and L53, also at an induction coupling factor +M. Meanwhile, the inductors L21 and L61 are similarly electrically connected to each other through induction coupling at an induction coupling factor +M, the inductors L22 and L62, at an induction coupling factor -M, and the inductors L23 and L63, at an induction coupling factor +M respectively.

In the parallel connection multi-stage hand-pass filter having the construction as described so far, at the input end T1 thereof, impedance when the ground shortcircuiting point is viewed from the connecting point at the transmission line TL2 side in the transmission line TL11 through the inductor impedance L51, impedance when the ground shortcircuiting point is viewed from the connecting point at the transmission line TL1 side in the transmission line TL12 through the inductor L52, and impedance when the ground shortcircuiting point is viewed from the connecting point at the input end T1 side in the transmission line TL13 through the inductor L53, are respectively set to become infinity, while the inductors L51, L52 and L53 are connected in parallel relation to the input end T1 through the transmission lines TL1, TL2, TL11, TL12 and TL13 functioning as impedance matching means.

Meanwhile, at the output end T2 thereof, impedance when the ground shotcircuiting point is viewed from the connecting point at the output end T2 side in the transmission line TL 21 through the inductor L61, impedance when the ground shotcircuiting point is viewed from the connecting point at the transmission line TL 4 side in the transmission line TL22 through the inductor L62, and impedance when the ground shortcircuiting point is viewed from the connecting point at the transmission line TL3 side in the transmission line TL23 through the inductor L63, are respectively set to become infinity, while the inductors L61, L62 and L63 are connected in parallel relation to the output end T2 through the transmission lines TL3, TL4, TL21, TL22 and TL23 functioning as impedance matching means.

Accordingly, the respective series connection resonance circuits 21,22 and 23 are respectively connected in parallel relation between the signal input and output ends T1 and T2 through the impedance matching means referred to above.

When a microwave signal is applied to the input end T1 of the parallel connection multi-stage band-pass filter 20a constructed as above, said microwave signal is distributed to pass through the respective resonance circuits 21,22 and 23, and thereafter, composed to be outputted from the output end T2. It is to be noted here that the signal passing through the resonance circuit 21 is of a signal component having a resonance frequency f1 or thereabout, the signal passing through the resonance circuit 22 is of a signal component having a resonance frequency f2 or thereabout, and the signal passing through the resonance circuit 23 is of a signal component having a resonance frequency f3 or thereabout. Accordingly, the frequency characteristic of the positive direction transfer function between the input and output ends T1 and T2 will become a characteristic in which the frequency characteristic of the positive direction transfer function for each of the resonance circuits 21, 22 and 23 is overlapped or superposed.

In the above band-pass filter 20a as shown in Fig.2(a), the induction coupling factor between the inductors L22 and L62 is set to be -M, while that between the other two inductors is set to be +M.

More specifically, the phase of the signal passing through the resonance circuit 22 having the resonance frequency f2 located at the intermediate portion between the two resonance frequencies f1 and f3 of the three resonance frequencies f1,f2, and f3 is inverted with respect to phases of signals passing through the other resonance circuits 21 and 23 so as to be composed at the output end T2.

The above arrangement is made by the reason as follows. That is to say, if the above inversion is not effected, at the frequency f12 generally in the vicinity of the central portion between the resonance frequencies f1 and 52, the relation between the phase θ21 of the signal passing through the resonant circuit 21 and the phase θ22 of the signal passing through the resonance circuit 22 becomes an inverted relation as, for example, in θ21=-θ22, and similarly, at the frequency f23 generally in the vicinity of the central portion between the resonance frequencies f2 and f3, the relation between the phase of the signal passing through the resonant circuit 22 and the phase of the signal passing through the resonance circuit 23 becomes an inverted relation, whereby attenuation poles are formed at the frequencies f12 and f23 of the frequency characteristic of the positive direction transfer function in said band-pass filter, and thus, said frequency characteristic does not become flat. Therefore, the symbols of the induction coupling factor are inverted for the respective neighboring frequencies as described above.

It should be noted here that although the symbols of the induction coupling factor are inverted for the respective adjacent frequencies as described above, the concept of the present invention is not limited to the above, but it may be so modified that, through adjustment of electrical length of the transmission line, the phases of the respective signals passing through the resonance circuits having two neighboring resonance frequencies at the respective resonance frequencies, become in the inverted relation. In the above case, similar modification may be possible even when the resonance circuits are generally provided in a plurality of n stages.

Moreover, the reason why the input end T1 is provided at the connecting point between the transmission lines TL1 and TL13, instead of the connecting point between the lines TL2 and TL11 or the lines TL1 and TL2, is to make generally constant, the transmission loss of the respective signals passing through the resonant circuits 21,22 and 23.

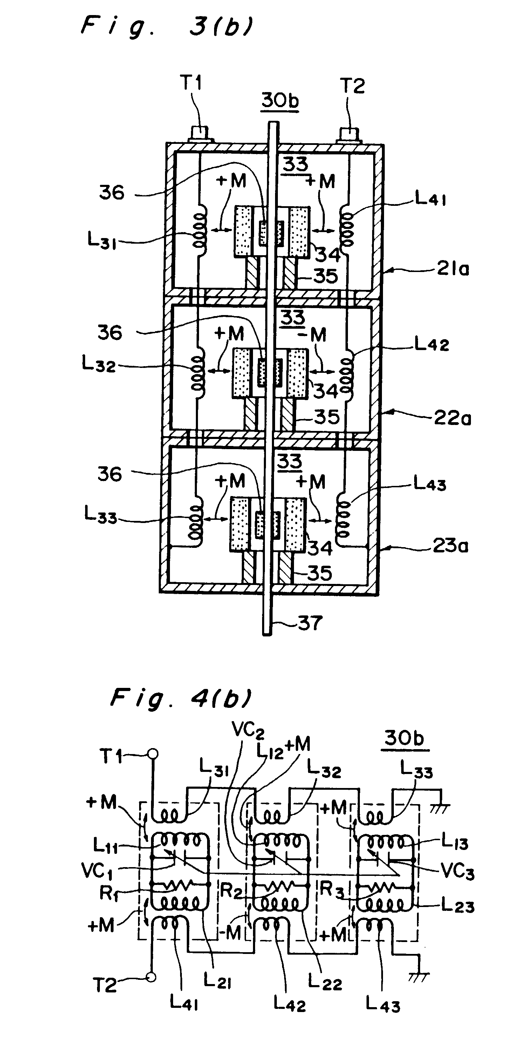

Fig. 3(a) shows the parallel connection multi-stage band-pass filter 30a in which the resonators in Fig. 2(a) are replaced by TE_{01δ} mode dielectric resonators, while Fig. 4(a) gives an equivalent circuit of said band-pass filter 30a. In Figs. 3(a) and 4(a), like parts in Fig. 2(a) are designated by like reference numerals.

The parallel connection multi-stage filter 30a in Fig. 3(a) thus obtained is one used for the channel filter 2 incorporated in the radio frequency signal combining/sorting device employed in the base station of the cellular system described earlier with reference to Fig. 16.

The parallel connection multi-stage filter 30a in Fig. 3(a) constituting the above channel filter 2 includes three dielectric resonators 21a, 22a, and 23a, which are respectively connected in parallel between the input end T1 and output end T2 by the input coaxial cable 31 and output coaxial cable 32. Here, the input side coaxial cable 31 corresponds to the transmission lines TL1, TL2, TL11, TL12 and TL13, while the output side coaxial cable 32 corresponds to the transmission lines TL3,TL4, TL21,TL22, and TL23.

Each of said dielectric resonators 21a, 22a and 23a is constituted by attaching the TE_{01δ} mode dielectric resonator 34 of a ring or annular shape, onto a support base 35 having the same coefficient of linear expansion as said resonator, at a central portion in a shielded cavity 33.

The shielded cavity 33 is constituted by baking a silver electrode on the outer surface of a rectangular box-like casing of a ceramic material having the same coefficient of liner expansion as above.

A coil, for example, of one turn constituting an inductor L51 and another coil, for example, of one turn constituting an inductor L61 are provided within the shielded cavity 33 of the dielectric resonator 21a so as to be coupled with a magnetic filed of the TE_{01δ} mode dielectric resonator 34. One end of the coil for the inductor L51 is connected to the central conductor of the coaxial cable 31, with its other end connected to the ground conductor of the coaxial cable 31. Meanwhile, one end of the coil for the inductor L61, is connected to the central conductor of the coaxial cable 32, with its other end connected to the ground conductor of the coaxial cable 32. Moreover, two coils respectively constituting inductors L52 and L62 are similarly provided within the shielded cavity 33 of the resonator 22a, while two coils constituting inductors L53 and L63 are disposed in the shielded cavity 33 of the resonator 23a.

Within each of the TE_{01δ} mode dielectric resonators 34, a small columnar dielectric member 36 is disposed for frequency tuning to effect the tuning action by being moved in a gradient of electric field, thereby to vary the resonance frequencies of the respective dielectric resonators 34.

The columnar dielectric members 36 of the respective resonators 34 for the tuning are fixed on one shaft 37, and by displacing said shaft 37 in directions indicated by arrows Al, the resonance frequencies for the three TE 01δ mode dielectric resonators 34 may be adjusted simultaneously.

In the equivalent circuit of the parallel connection multi-stage band-pass filter 30a as shown in Fig. 4(a), the respective dielectric resonators 34 are constituted by the parallel resonance circuit in which two inductors L11 and L21, a variable capacitor VC1 and a loss resistor R1 are connected in parallel to each other, the paralle resonance circuit in which two inductors L12 and L22, a variable capacitor VC2 and a loss resistor R2 are connected in parallel to each other, and the parallel resonance circuit in which two inductors L13 and L23, a variable capacitor VC3 and a loss resistor R3 are connected in parallel to each other.

In the band-pass filter 30a of the channel filter having the construciton as describe above, an input signal having power spectrum, for example, of a band width at 300 KHz is generally uniformly distributed according to the respective resonance frequencies, from the input terminal T1, through the input side coaxial cable 31, into three resonators 21a, 22a, and 23a. The input signal thus distrubuted is composed at the rspective connecting points through the output side coaxial cable 32, and thereafter, outputted from the output end T2.

Fig. 5 shows the fequency characteristic curve 100 of the positive direciton transfer function, of the band-pass filter 30a in Fig. 3(a), the frequency characteristic curves 101,102 and 103 of the positive direction transfer fuctions of the respective resonators 34, and fequency characteristic curve 104 of the group delay time of said band-pass filter 30a.

The above band-pass filter 30a has a pass-band width at 300KHz, with the center frequencey thereof at 955.0 MHz. Meanwhile, the respective resonance frequencies f1,f2 and f3, loads Q(QL), and non-loads Q(Qo) of the three resonators 34 constituting said paralle connection multi-stage band-pass filter 30a are as follows.
(a) The dielectric resonator 34 constituting the first resonator 21a.
   Resonance frequency fl=954.8 MHz
   QL=4300, Qo=22000
(b) The dielectric resonator 34 constituting the second resonator 22a.
   Resonance frequency f2=955.0 MHz
   QL=3400, Qo=22000
(c) The dielectric resonator 34 constituting the third resonator 23a.
   Resonance frequency f3=955.2 MHz
   QL=4300, Qo=22000

From Fig. 5, it is seen that, in the above band-pass filter 30a, the amount of variation for the frequency characteristic 104 of the group delay time in the pass-band region thereof is approximately within the range of 60 n sec between 1920 n sec and 1980 n sec.

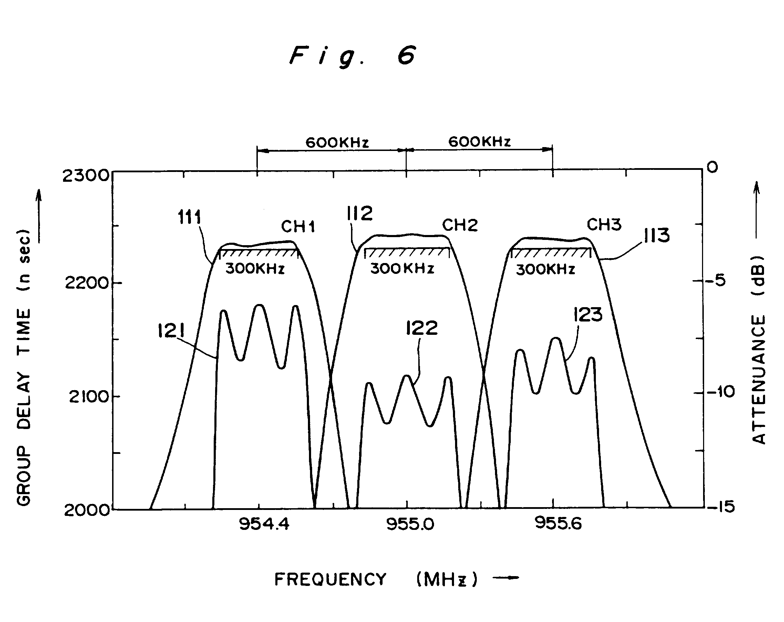

Furthermore, when a radio frequency signal combining/sorting device of three channels is constituted by the band-pass filter 30a as described so far, the frequency caracteristics 111,112 and 113 in the positive direction transfer function for the respective channels, and the frequency characteristics 121,122 and 123 for the group delay time are shown in Fig. 6.

The center frequency for the channel 1 is 954.4 MHz, that for the channel 2 is 955.0 MHz, and that for the channel 3 is 955.6 MHz.

With respect to the loads Q (QL) of the respective resonators, it is so arranged that the loads Q(QL) of the resonators having the highest and lowest resonance frequencies f1 and f3 are set to be the same, and the load Q(QL) of the resonator having an intermediate resonance frequency f2 is set to be slightly smaller than the loads Q(QL) of the resonators having the highest and lowest resonance frequencies f1 and f3.

The reason for the above setting is such that, since the characteristic of the positive direction transfer function in the intermediate resonance frequency f2 is affected by a skirt portion of the frequency characteristic curve of the positive direction transfer function of each resonator, thereby to increase said transfer function in order to flatten the frequency characteristic of said band-pass filter which is the superpositioin of the frequency characteristic of the positive direction transfer functions of the respective resonators, the loads Q(QL) of the respective resonators are set as described above.

Although the relation between the setting of the loads Q (QL) of the respective resonators and frequency charactristics depends on the setting of resonance frequencies, etc. of the resonators, it should preferably be so constructed, in the general practice, that in the respective resonators referred to above, the resonators respectively having the highest and lowest resonance frequencies have approximately the same i.e. equal load Q, while the other resonator having intermediate resonance frequency has the load Q approximatley the same as i.e. equal to or smaller than said approximately the same load Q, whereby frequency characteristics of more flat positive direction transfer function, and of still more flat group delay time can be achieved.

Hereinbelow, setting of the load Q for the respective resonators will be described in detail.

Now, with respect to a parallel connection multi-stage band-pass filter in three stages, on the assumption that the respective resonators have resonance frequencies f1,f2 and f3 as shown in Fig. 5 and the same non-load Q(Qo)=22000, the loads Q for the respective resonators are set as follows. (Subsequently, the load Q of the resonator with the resonance frequency fl is represented by QL1, that of the resonator with the resonance frequency f2, by QL2, and that of the resonator with the resonance frequency f3, by QL3).
Setting example 1
   QL1=4300, QL2=3400 to 4300, more preferably 3500,
   QL3=4300
Setting example 2
   QL1=4300, QL2=3350 to 3450, more preferably 3400,
   QL3=4300
Setting exmaple 3
   QL1=4300, QL2=2400 and thereunder QL3=4300
Setting example 4
   QL1=3000, QL2=2350 to 2450, more preferably 2400
   QL=3000

The above setting example 1 corresponds to the case of the appended Claim 21, and the loads Q of the respective resonators are so set that the variation amount of the positive direction transfer function within the predetermined pass-band region of said band-pass filter becomes small when the non-load Q of each resonator is finite, whereby frequency characteristic of extremely flat positive direction transfer function may be obtained.

The setting example 2 corresponds to the case of the appended Claim 22, and the loads Q of the respective resonators are so set that the respective variation amounts at a plurality of variation points to be produced in the frequency characteristic of group delay time within the predetermined pass-band region of said band-pass filter, become approximately the same or equal to each other, whereby favorable frequency characteristic of group delay time which is still more flat, can be achieved.

The setting example 3 shows the setting of the loads Q of the respective resonators for obtaining characteristic similar to that of the group delay time of the conventional Chebyshev type band-pass filter.

The setting example 4 corresponds to the case of the appended Claim 23, and the loads Q of the respective resonators are so set that the respective variation amounts at a plurality of variation points to be produced in the frequency characteristic of group delay time within the predetermined pass-band region of said band-pass filter, become approximatly zero whereby favorable frequency characteristic of group delay time which is extremely flat, can be achieved.

It is to be noted here that, in the case of a parallel connection multi-stage band-pass filter in four stages, the loads Q(QL) of the resonators in two resonance frequencies at the intermediate portion among four resonance frequencies different from each other, should preferably be set to be approximately the same as or smaller than the load Q(QL) of the resonators with the lowest and highest resonance frequencies. Moreover, in the case of a parallel connection multi-stage band-pass filter in five stage, the loads Q(QL) of the resonators in three intermediate resonance frequencies among five resonance frequencies different from each other, should preferably be set to be approximately the same as or smaller than the load Q(QL) of the resonators with the lowest and highest resonant ferquencies, and of the above intermediate three resonance frequencies, the load Q(QL) of the resonator with the resonance frequency at the intermediate portion thereof should preferably be set approximately the same as or smaller than the loads Q(QL) of the other resonators. Subsequently, with respect to parallel connection multi-stage band-pass filter in more than six stages, the load Q(QL) of each resonator may be set in the similar manner.

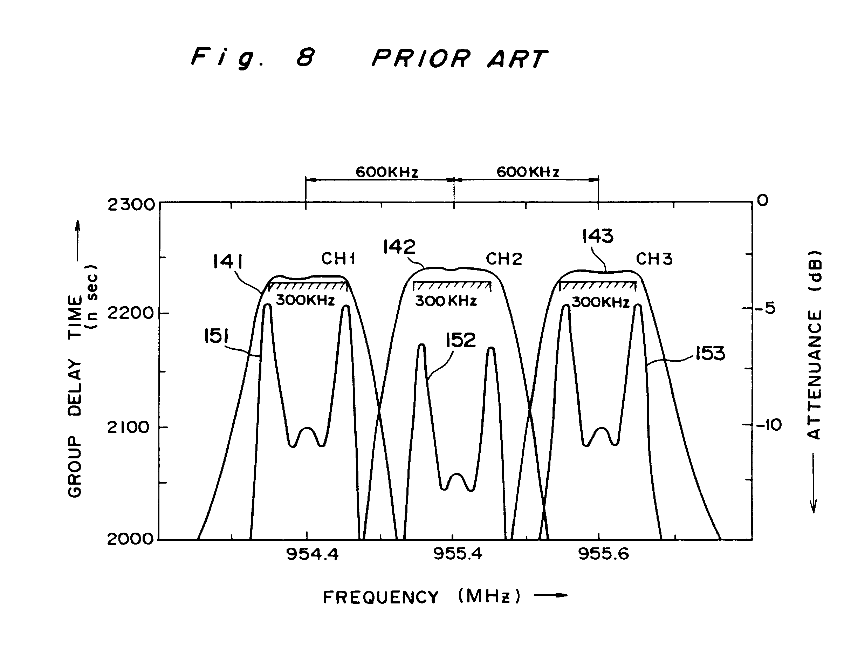

Regarding the parallel connection multi-stage band-pass filter 30a as described so far, with respect to the conventional series connection multi-stage band-pass filter 8 shown in Fig. 17, characteristic corresponding to those in Figs. 5 and 6 are shown in Figs. 7 and 8.

it is to be noted here that in Fig. 7, a curve 130 represents the frequecy characteristic of the positive direction transfer function of said band-pass filter 8, and another curve 131 denotes the frequency characteristic of the group delay time thereof. Similarly, in Fig. 8, curves 141,142 and 143 show frequency characteristics of the positive direction transfer functions in the respective channels, and curves 151,152 and 153 respectively represent the ferquency characteristics of the group delay time in the respective channels.

From Figs. 7 and 8, it is seen that, in the known series connection multi-stage filter 8, the group delay time has a variation amount in the order of about 130 n sec or over within the pass-band region of said filter 8.

It is also seen that, in the band-pass filter 30a of the present embodiment in Fig. 3(a), the group delay time characteristc has been remarkaby improved as compared with the conventional filter 8 for still more flat frequency characteristic.

Fig. 3(b) shows a modification 30b of the parallel connection band-pass filter 30a in Fig. 3(a), with an equivalent circuit thereof given in Fig. 4(b). In Figs. 3(b) and 4(b), like parts in Figs. 3(a) and 4(a) are designated by like refeence numerals.

In the parallel connection multi-stage band-pass filter 30b as shown in Fig. 3(b), in the similar manner as in the fundamental circuit in Fig. 1, inductors L31,L32 and L33 respectively connected with the input side inductors L11,L12 and L13 of the respective resonators 34 thorugh induction coupling are connected in series between the input end T1 and the gound, while inductors L41,L42 and L43 to be respectively connected with the output side inductors L21,L22 and L23 of the respective resonators 34 are connected in series between the output end T2 and the ground. Since other constructions are generally similar to those as shown in Fig. 3(a), detailed description thereof is abbreviated here for brevity of explanation.

Fig. 2(b) shows a modification 20b of the parallel connection multi-stage band-pass filter 20a in Fig. 2(a), with like parts in Fig. 2(a) being designated by like reference numerals.

In the modified filter 20b in Fig. 2(b), the input end T1 is connected to the ground through a transmission line TL31 and an inductor L51, and also, to the ground via a transmission line TL32 and an inductor L52. The input end T1 is also connected to the ground through a transmission line TL33 and an inductor L53.

In the above arrangement, the electrical length from the input end T1 side of the transmission line TL 31 to the ground shortcircuiting point through the inductor L51 is set at λg/4, the electrical length from the input end T1 side of the transmission line TL32 to the ground shortcircuiting point through the inductor L52 is set at λg/4, and the electrical length from the input and T1 side of the transmission line TL33 to the ground shortcircuitig point through the inductor L53 is also set at λg/4. Meanwhile, the input end T2 is connected to the ground through a transmission line TL41 and an inductor L61, and also, to the ground via a transmission line TL42 and an inductor L62. The input end T2 is also connected to the ground through a transmission line TL43 and an inductor L63.

In the above arrangement, the electrical length from the output end T2 side of the transmission line TL41 to the ground shortcircuiting point through the inductor L61 is set at λg/4, the electrical length from the output end T2 side of the transmission line TL42 to the ground shortcircuiting point through the inductor L62 is set at λg/4, and the electrical length from the output end T2 side of the transmission line TL43 to the ground shortcircuiting point through the inductor L63 is also set at λg/4.

The resonance circuits 21,22 and 23 are constructed in the similar manner as in Fig. 2(a), and the coupling between the respective inductors is effected by induction coupling for electrical connection also in the similar manner as in Fig. 2(a).

In the parallel connection multi-stage band-pass filter 20b having the construction as described so far, at the input end T1 side thereof, impedance when the ground shortcircuiting point is viewed from the connection point at the input end T1 side in the transmission line TL31 through the inductor L51, impedance when the ground shortcircuiting point is viewed from the connecting point at the input end T1 side in the transmission line TL32 through the inductor L52, and impedance when the ground shortcircuiting point is viewed from the connecting point at the input end T1 side in the transmission line TL33 through the inductor L53, are respectively set to become infinity , while the inductors L51,L52 and L53 are respectively connected in parallel relation to the input end T1 through the transmission lines TL31,TL32, and TL33, functioning as impedance matching means.

Meanwhile, at the output end T2 side thereof, impedance when the ground shortcircuiting point is viewed from the connecting point at the output end T2 side in the transmission line TL41 through the inductor L61, impedance when the ground shortcircuiting point is viewed from the connectin point at the output end T2 side in the transmission line TL42 through the inductor L62, and impedance when the ground shortcircuiting point is viewed from the connecting point at the output end T2 side in the transmission line TL43 through the inductor L63, are respectively set to become infinity, while the inductors L61,L62 and L63 are connected in parallel relation to the output end T2 through the transmission lines TL41,TL42, and TL43 functioning as impedance matching means.

Accordingly, the respective series connection resonance circuits 21,22 and 23 are respectively connected in parallel relation between the signal input and output ends T1 and T2 through the impedance matching means referred to above.

The parallel connection multi-stage band-pass filter 20b having the construction as described above has the function and effect similar to those of the band-pass filter 20a shown in Figs. 2(a)

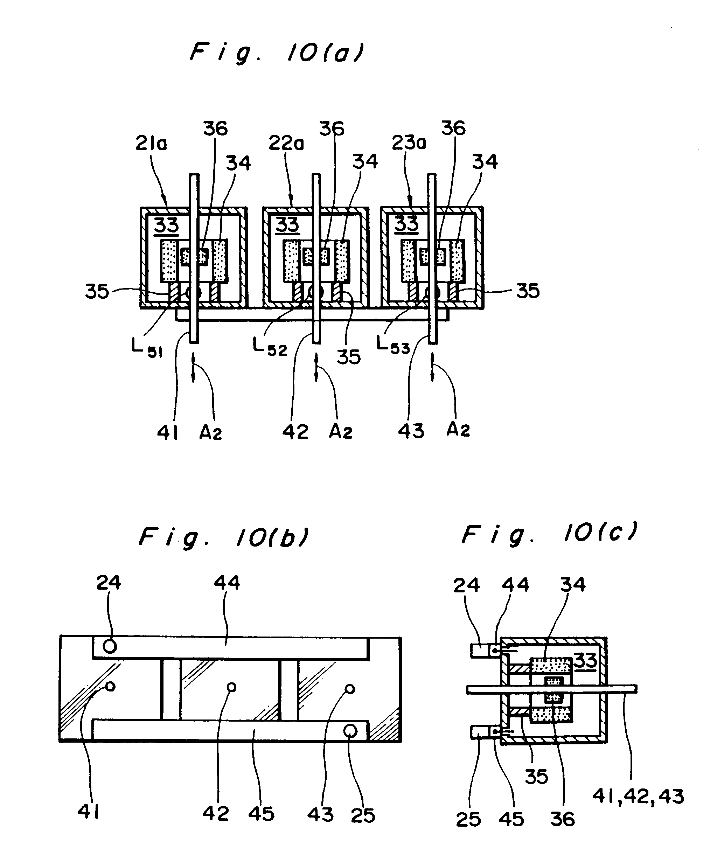

In the channel filter 30a explained with reference to Fig. 3(a), although it is so arranged that the respective columnar dielectric members 36 of the three TE_{01δ} mode dielectric resonators are fixed on one shaft 37 so as to simultaneously adjust the resonance frequencies of the three resonators 21a,22a and 23a by moving said shaft, the arrangement may be so modified for example, as shown in Figs. 10(a),10(b) and 10(c), that three shafts 41,42 and 43 are respectively provided for the three TE_{01δ} mode dielectric resonators 21a,22a and 23a, thereby to adjust resonance frequencies of said resonators independently by moving said shafts 41,42 and 43 in the directions indicated by arrows A2.

As is most clarly seen from Fig. 10(b), the channel filter 30a referred to above includes an input side coaxial cable 44 and an output side coaxial cable 46 disposed in a parallel relation to each other, and the TE_{01δ} mode dielectric resonators 21,22a and 23a as described with reference to Fig. 3(a), disposed on said input and otput side coaxial cables 44 and 45.

In the arrangement of Figs. 10(a),10(b) and 10(c), by moving the respective shafts 41,42 and 43 for the resonators 21a, 22a and 23a, it is possible to independently alter the resonance frequencies of the TE_{01δ} mode dielectric resonators 21a,22a, 23a.

### 2nd embodiment

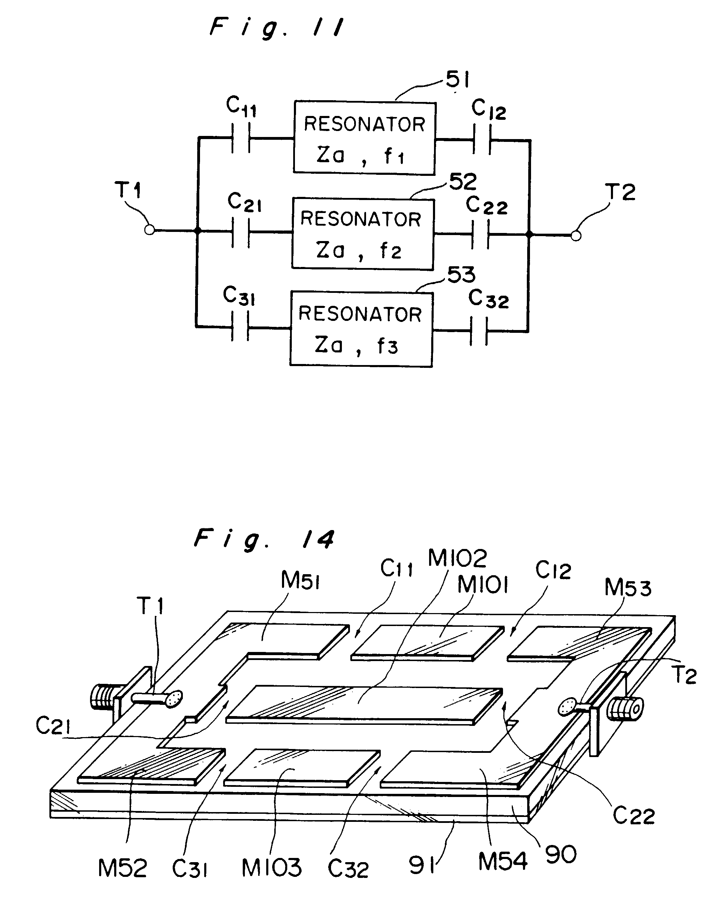

Fig. 11 shows a fundamental circuit of a capacity coupled type parallel connection multi-stage band-pass filter.

In the filter of Fig. 11, the signal input end T1 is connected to the output end T2 through a coupling capacitor C11, a resonator 51 having a characteristic impedance Za and a resonance frequency f1 and another coupling capacitor C12, and, through a coupling capacitor C21, a resonator 52 having a characteristic impedance Za and a resonance frequency f2 and another coupling capacitor C22, and also through a coupling capacitor C31, a resonator 53 having a characteristic impedance Za and a resonance frequency f3 and another coupling capacitor C32.

In the above arrangement, the resonance frequencies f1,f2 and f3 of the respective resonators 51,52 and 53 are set to be different from, but close to each other as in teh first embodiment so as to function as a band-pass filter having the above resonance frequencies as the center frequency for the pass-band.

Accordingly, the parallel connection multi-stage band-pass filter as shown in Fig. 11 has the pass-band region in which the pass-bands of the respective resonators 51,52 and 53 are piled one upon another.

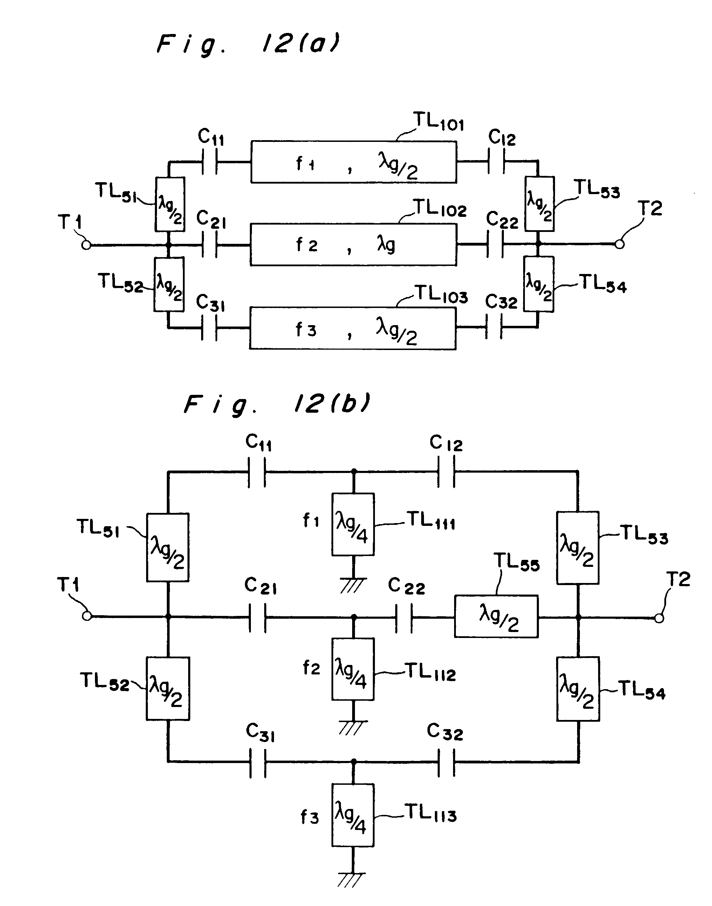

Fig. 12(a) shows a capacity coupled type parallel connection multi-stage band-pass filter which employs transmission lines as resonators.

In Fig. 12(a), a transmission line TL101 having an electrical length of λg/2 is used as the resonator 51, a transmission line TL102 having an electrical length of λg is used as the resonator 52, and a transmission line TL103 having an electrical length of λg/2 is used as the resonator 53. In the above arrangement, the respective transmissionlines TL101, TL102 and TL103 respectively constitute resonators with an electrical length of λg/2.

As compared with the fundamental circuit of Fig. 11, in the band-pass filter of Fig. 12(a), at the input end T1 side, a transmission line TL51 having an electrical length of λg/2 is inserted between the input end T1 and the capacitor C11 for impedance matching, while another transmission line TL52 having an electrical length of λg/2 is also inserted between the input end T1 and the capacitor C31. Meanwhile, at the output end T2 side, a transmission line TL 53 having an electrical length of λg/2 is inserted between the output end T2 and the capacitor C12 for impedance matching, while another transmission line TL54 having an electrical length of λg/2 is inserted between the output end T2 and the capacitor C32.

It is to be noted here that the reason for setting the electrical length of the transmission line TL102 having the intermediate resonance frequency f2 as λg, and the electrical length of the transmission lines TL101 and TL103 having resonance frequencies f1 and f3 as λg/2, is to invert the phase of the signal passing through the transmission line TL102 as compared with the phase of the signals passing through other transmission lines TL101 and TL103 in the similar manner as in the first embodiment.

In the band-pass filter having the construction as described above, the transmission lines TL101, TL102 and TL103 functioning as resonators are connected between the signal input end T1 and the output end T2, in a parallel relation through the coupling capacitors C11,C12, C21,C22, C31 and C32, and the transmission lines TL51, TL52, TL53 and TL54 for the impedance matching.

When a microwave signal is applied to the input end T1 of this band-pass filter, said microwave signal is distributed to pass through the transmission lines TL101,TL102, and TL103 and thereafter, composed to be outputted from the output end T2.

The above band-pass filter has the function and effect similar to those of the band-pass filter as described with reference to Figs. 2(a) and 2(b).

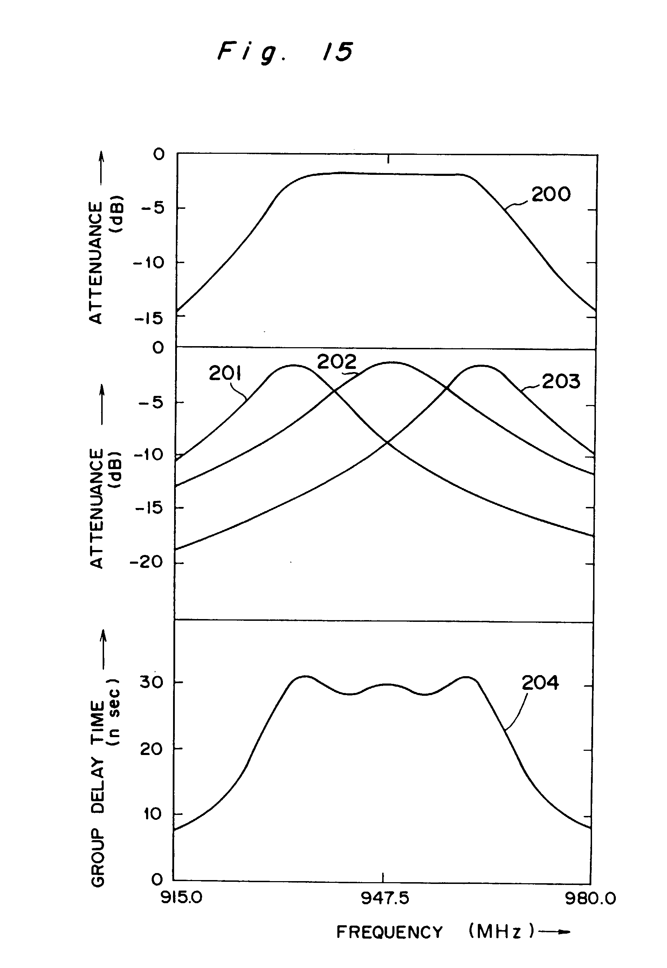

Fig. 15 shows the characteristic curve 200 of the positive direction transfer function of the band-pass filter shown in Fig. 12(a), the frequency characteristics curves 201,202 and 203 of the positive direction transfer functions of the respective transmission lines TL101,TL102, and TL103 functioning as resonators, and frequency characteristic curve 204 of the group delay time of said band-pass filter.

The above band-pass filter to be used for a receiving filter of a moving unit for a mobile communication system has a pass-band width of 25 MHz, with the center frequency thereof at 947.5 MHz. Meanwhile, the respective resonance frequencies fl,f2 and f3, loads Q(QL), and non-loads Q(Qo) of the three transmission lines TL101,TL102,and TL103 constituting said parallel connection multi-stage band-pass filter are as follows.
(a) Transmission line TL101
   Resonance frequency f1=936.85 MHz
   QL=65,Qo=430
(b) Transmission line TL102
   Resonance frequency f2=947.5 MHz
   QL=25,Qo=430
(c) Transmission line TL103
   Resonance frequency f3=958.15MHz
   QL=65,Qo=430

From Fig. 15, it is seen that in the above band-pass filter of Fig. 12(a), the frequency characteristics as represented by the curves 200 to 203 of the positive direction transfer function are generally flat within the predetermined pass-band width of 25MHz, with the variation amount of the frequency characteristic as represented by the curve 204 of the group delay time being about 2 nsec.

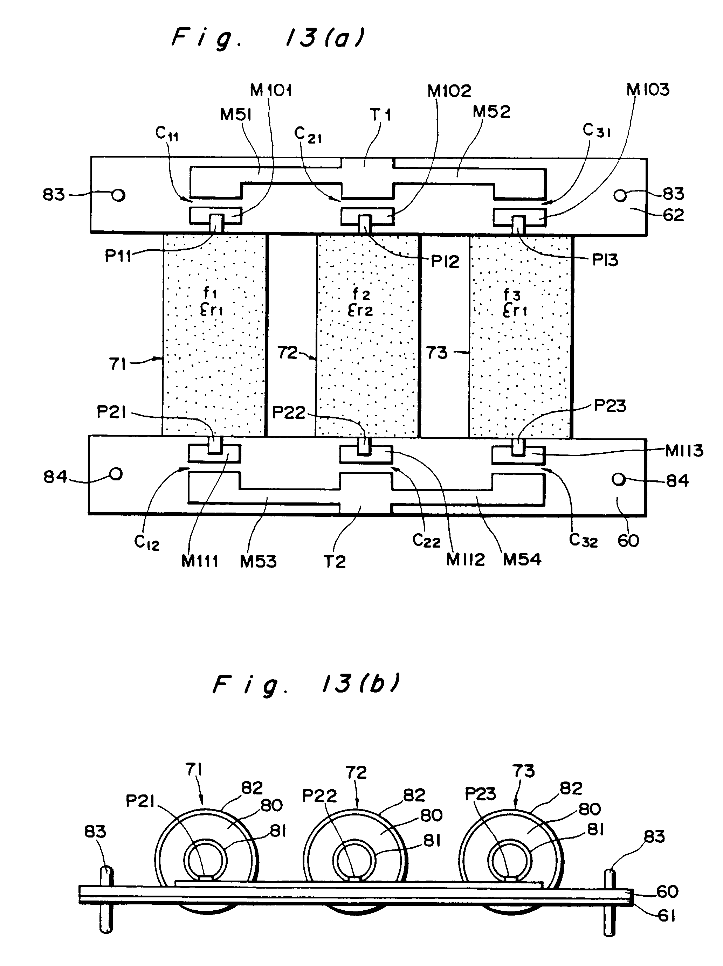

Figs. 13(a) and 13(b) show a parallel connection multi-stage band-pass filter which employs coaxial dielectric resonators 71,72 and 73 as resonators, and micro-strip lines M51,M52,M53 and M54 as transmission lines for the impedance matching.

In the band-pass filter of Figs. 13(a) and 13(b), the micro-strip line M51 with an electrical length of λg/2, and the micro-strip line M52 with an electrical length of λg/2 branched from the input end T1 are formed on a dielectric substrate 62 having a grounding conductor over its entire reverse surface. Conductors M101 and M103 are formed in positions spaced from the edges of the respective micro-strip lines by a predetermined interval, while a conductor M102 is formed in a position spaced from the conductor of the input end T by a predetermined distance. Here, the respective conductors M101,M102, and M103 are formed so as to be arranged on one straight line through the same interval provided therebetween. Meanwhile, in the dielectric substrate 62, a capacitor C11 is formed between the corresponding edges of the micro-strip line M51 and the conductor M101, a capacitor C21 is formed between the corresponding edges of the conductor of the input end T1 and the conductor M102, and another capacitor C31 is formed between the corresponding edges of the micro-strip line M52 and the conductor M103. It is to be noted here that the dielectric substrate 62 is supported by a plurality of support rods 83.

On the other hand, the micro-strip line M53 with an electrical length of λg/2, and the micro-strip line M54 with an electrical length of λg/2 branched from the output end T2 are formed on a dielectric substrate 60 having a grounding conductor 61 over its entire reverse surface. Conductors M111 and M113 are formed in positions spaced from the edges of the respective micro-strip lines M53 and M54 by a predetermined interval, while a conductor M112 is formed in a position spaced from the conductor of the output end T2 by a predetermined distance. Here, the respective conductors M111,M112,and M113 are formed so as to be arranged on one straight line through the same interval provided therebetween. Meanwhile, in the dielectric substrate 60, a capacitor C12 is formed between corresponding edges of the micro-strip line M53 and the conductor M111, a capacitor C22 is formed between the corresponding edges of the conductor of the output end T2 and the conductor M112, and another capacitor C32 is formed between the corresponding edges of the micro-strip line M54 and the conductor M113. It is to be noted here that the dielectric substrate 60 is supported by a plurality of support rods 84.

The coaxial dielectric resonator 71 is constituted by a cylindrical dielectric member 80 having a dielectric constant εr1 and an electrical length of λg/2, an inner peripheral conductor 81 formed on the inner peripheral face of the dielectric member 80, and an outer peripheral conductor 82 formed on the outer peripheral face of said dielectric member 80, and has a resonance frequency of fl. To the inner peripheral conductor 81, pins P11 and P21 projecting from opposite faces of the resonator 71 are connected by soldering, and the respective pins P11 and P21 are respectively connected to the conductors M101 and M111 also by soldering. The coaxial resonator 72 has the construction similar to that of the above resonator 71, and pins P12 and P22 connected to the inner peripheral conductor 81 thereof are respectively connected by soldering to the above conductors M102 and M112 by soldering. Moreover, the coaxial dielectric resonator 73 is constructed in the similar manner as in the resonators 71 and 72, and pins P13 and P23 connected to the inner peripheral conductor 81 thereof are respectively connected to the conductors M103 and M113 by soldering.

It is to be noted here that, although the respective dielectric resonators 71,72 and 73 have the same electrical length of λg/2, the resonator 72 is provided with the dielectric constant ετ2 different from other dielectric resonators 71 and 73, so as to invert the signal passing through said resonator 72 with respect to signals passing through other dielectric resonators 71 and 73 in the similar manner as in the first embodiment.

Fig. 14 shows a capacity coupled type parallel connection multi-stage band-pass filer in which micro-strip lines M101,M102 and M103 as employed as resonators. In Fig. 14, like parts in Fig. 13(a) are designated by like reference numerals for brevity of explanation.

In the band-pass filter of Fig. 14, on a dielectric substrate 90 formed with a grounding electrode 91 over its entire reverse surface, micro-strip lines M51,M52,M53, M54,M101,M102, and M103 are formed. Here, the micro-strip lines M101, M102 and M103 respectively correspond to the transmission lines TL101,TL102 and TL103 in Fig. 12(a).

Fig. 12(b) shows a modification of the capacity coupled parallel connection multi-stage band-pass filter shown in Fig. 12(a).

In the band-pass filter of Fig. 12(b), a transmission line TL111 with an electrical length of λg/4 and shortcircuited at one end to the ground is used as the resonator 51, a transmission line TL112 with an electrical length of λg/4 and shortcircuited at one end to the ground is employed as the resonator 52, and a transmission line TL113 with an electrical length of λg/4 and shortcircuited at one end to the ground is utilized as the resonator 53. Here, the transmission lines TL111,TL112 and TL113 respectively constitute resonators with an electrical length of λg/4.

More specifically, as compared with the circuit of the band-pass filter shown in Fig. 12(a), in the band-pass filter of Fig. 12(b), the coupling capacitors C11 and C12 are directly connected, with the transmission line TL111 connected to the ground at one end being connected to a junction between the capacitors C11 and C12, the coupling capacitors C21 and C22 are directly connected, with the transmission line TL112 connected to the ground at one end being connected to a junction between the capacitors C21 and C22, and the coupling capacitors C31 and C32 are directly connected, with the transmission line TL113 connected to the ground at one end being connected to a junction between the capacitors C31 and C32. Moreover, between the capacitor C22 and the output end T2, a transmission line TL55 having an electrical length of λg/2 is inserted for the phase inversion of the signals in the similar manner as in the first embodiment.

The band-pass filter of Fig. 12(b) having the construction as described so far has the effect and function similar to the band-pass filter of Fig. 12(a) except for the employment of the transmission lines TL111,TL112 and TL113 as the resonators with the electrical length of λg/4.

### Comparison of features between the parallel connection multi-stage band-pass filter and the series connection multi-stage band-pass filter

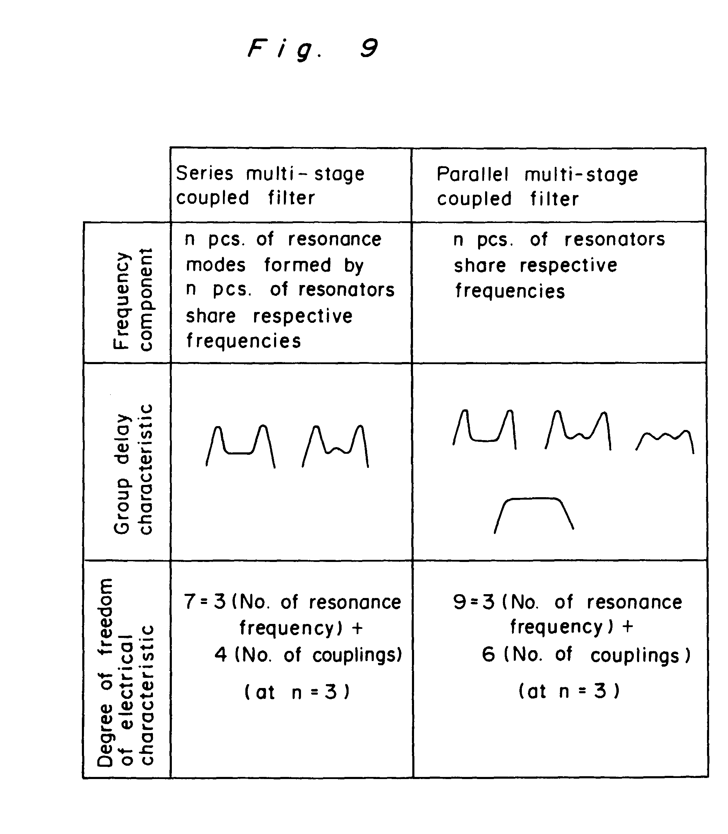

Comparison of the feature possessed by the parallel connection multi-stage band-pass filter according to the present invention and the feature of the conventional series connection multi-stage band-pass filter is shown in Fig. 9, in which the term "degree of freedom of electrical characteristic" is to be defied as the sum of the number of the resonance frequencies of resonance circuit which can be set independently and the number of couplings present between the input and output of said band-pass filter.

As is seen from Fig. 9, in the parallel connection multi-stage band-pass filter, for example, of three stage, since the number of resonance frequencies is 3 and the number of couplings is 6, the degree of freedom of electrical characteristic is to be 9. Accordingly, in the parallel connection multi-stage band-pass filter in three stage, the degree of freedom of electrical characteristic is increased by 2 as compared with that of the series connection multi-stage band-pass filter of three stage, whereby the degree of freedom for adjustment of the frequency characteristic of said band-pass filter such as the group delay characteristic, etc. is increased, and thus, for example, the frequency characteristic of the group delay characteristic may be more easily improved so as to be still more flat than in the conventional arrangements.

It should be noted here that in the simulation model of the parallel-coupled circuit as described earlier with reference to the prior art, although the vibration modes are coupled to each other between the respective resonators, such vibration modes between the respective resonators are not coupled to each other, but are independent of each other in the parallel connection multi-stage band-pass filter according to the present invention. Therefore, the frequency characteristic of said band-pass filter is represented by that in which the band-pass characteristics of the respective resonators (each functioning as a band-pass filter) constituting said band-pass filter are piled one upon another.

The above fact is the point in which the simulation model of the conventional parallel-coupled circuit differs from the parallel connection multi-stage band-pass filter of the present embodiment, whereby the degree of freedom of electrical characteristic as stated above can be achieved, and the various frequency characteristic such as the positive direction transfer function and the group delay time, etc. may be more readily flattened within the pass bans region as compared with the conventional arrangements.

### Other modifications

In the foregoing embodiments although TE 01δ mode dielectric resonators, coaxial dielectric resonators, and resonators constituted by transmission lines, i.e. transmission line type resonators, are employed as resonators, the concept of the present invention is not limited in its application to such embodiment alone, but dielectric resonators employing other oscillation modes or other kinds of resonators such as cavity resonators, semi-coaxial resonators, LC resonators, helical resonators, etc. may be employed depending on necessity.

Similarly, in the foregoing embodiments, the band-pass filter is constituted by connecting three resonators in a parallel relation to each other, but the arrangement may be, for example, so modified to constitute the band-pass filter b connecting, in parallel, a plurality of resonators in two or more than four pieces.

It should also be noted here that the parallel connection multi-stage band-pass filter according to the present invention as described so far may be applied not only to the channel filter of the radio frequency signal combining/sorting device for a mobile unit communication system or transmission/receiving filter for the moving unit, etc. but also, to other band-pass filters of different end uses in general. Particularly, in a digital mobile communication system in which audio signals or data signals are subjected to digital modulation for transmission, the band-pass filter having wider and more flat pass-band region, and frequency characteristic for wider and still more flat group delay time is require, and therefore, the band-pass filter according to the present invention is particularly useful as the band-pass filter constituting part of such digital mobile communication system.

Although the present invention has been fully described by way of example with reference to the accompanying drawings, it is to be noted here that various changes and modifications will be apparent to those skilled in the art. The scope of the present invention, is only limited by the appended claims.

## Claims

1. A parallel connection multi-stage band-pass filter comprising:
an input terminal (24, T₁) and an output terminal (25, T₂) for signals, and
a plurality of resonators (21, 22, 23, 34) each provided with first and second ports and having resonance frequencies different from and close to each other, one resonator (21, 22, 23, 34) being provided for each parallel passage of the bandpass filter,
**characterized by**
first and second impedance matching means connecting each resonantor (21, 22, 23, 34) with said input terminal (24, T₁) and said output terminal (25, T₂), respectively,
said first port of each of said resonators being electrically connected to said input terminal through said first impedance matching means by induction or capacity coupling, said second port of each of said resonators being electrically connected to said output terminal (25) through said second impedance matching means by the same kind of coupling as the first impedance matching means, and
said band-pass filter further comprising shielding means (33) for preventing coupling between said plurality of resonators (21, 22, 23, 34).

2. A parallel connection multi-stage band-pass filter as claimed in claim 1, wherein the respective resonators are dielectric resonators.

3. A parallel connection multi-stage band-pass filter as claimed in any of claims 1-2, wherein the respective resonators are transmission line type resonators.

4. A parallel connection multi-stage band-pass filter as claimed in claim 3, wherein said transimssion lines type resonators are coaxial dielectric resonators or micro-strip lines.

5. A parallel connection multi-stage band-pass filter as claimed in any of claims 1-4, wherein three resonators are provided and wherein wherein in said respective resonators, the resonators respectively having the maximum and minimum resonance frequencies have approximately the same load Q, whereby the remaining resonator having an intermediate frequency has a load Q' approximately the same as or smaller than said approximately the same load Q.

6. A parallel connection multi-stage band-pass filter as claimed in claim 5, wherein the load Q of each of said resonators is so set that the amount of variation of positive direction transfer function of said band-pass filter within a predetermined pass-band region becomes small when a non-load Q of each of said resonators is finite.

7. A parallel connection multi-stage band-pass filter as claimed in claim 5, wherein the load Q of each of said resonators is so set that respective amounts of variation at a plurality at variation points, to be produced in the frequency characteristic of group delay time within a predetermined pass-band region of said band-pass filter become approximately equal to each other.

8. A parallel connection multi-stage band-pass filter as claimed in claim 5, wherein the load Q of each of said resonators is so set that respective amounts of variation at a plurality of variation points, to be produced in the frequency characteristic of group delay time within a predetermined pass-band region of said band-pass filter become approximately zero.

9. A parallel connection multi-stage band-pass filter as claimed in any of claims 1-8, wherein phases in the respective resonant frequencies of the respective signals passing through the resonators having neighboring resonance frequencies are inverted to each other.

## Patentansprüche

1. Parallel geschaltetes mehrstufiges Bandpaßfilter mit:
einem Eingangsanschluß (24, T₁) und einem Ausgangsanschluß (25, T₂) für Signale, und
einer Mehrzahl Resonatoren (21, 22, 23, 34), die jeweils mit ersten und zweiten Anschlüssen versehen sind und jeweils unterschiedliche und nah beieinanderliegende Resonanzfrequenzen haben, wobei einer der Resonatoren (21, 22, 23, 34) für jeden parallelen Durchlaßweg des Bandpaßfilters vorgesehen ist,
**gekennzeichnet** durch
erste und zweite Impedanzanpaßmittel, um jeden Resonator (21, 22, 23, 34) jeweils mit dem Eingangsanschluß (24, T₁) und dem Ausgangsanschluß (25, T₂) zu verbinden,
wobei der erste Anschluß jedes Resonators über das erste Impedanzanpaßmittel durch induktive oder kapazitive Kopplung elektrisch mit dem Eingabeanschluß verbunden ist, der zweite Anschluß jedes Resonators über das zweite Impedanzanpaßmittel auf diesselbe Kopplungsart wie das erste Impedanzanpaßmittel elektrisch mit dem Ausgabeanschluß (25) verbunden ist, und
wobei das Bandpaßfilter desweiteren Abschirmmittel (33) zur Vermeidung von Kopplungen zwischen der Mehrzahl Resonatoren (21, 22, 23, 34) enthält.

2. Parallel geschaltetes mehrstufiges Bandpaßfilter nach Anspruch 1,
bei dem die jeweiligen Resonatoren dielektrische Resonatoren sind.

3. Parallel geschaltetes mehrstufiges Bandpaßfilter nach Anspruch 1 oder 2,
bei dem die jeweiligen Resonatoren Resonatoren vom Übertragungsleitungstyp sind.

4. Parallel geschaltetes mehrstufiges Bandpaßfilter nach Anspruch 3,
bei dem die Resonatoren vom Übertragungsleitungstyp koaxiale dielektrische Resonatoren oder Mikro-Strip-Leitungen sind.

5. Parallel geschaltetes mehrstufiges Bandpaßfilter nach einem der Ansprüche 1 bis 4,
bei dem drei Resonatoren vorgesehen sind, und wobei von den jeweiligen Resonatoren jene Resonatoren, die die maximale und minimale Resonanzfrequenzen haben, in etwa das gleiche Last-Q aufweisen, wobei der verbleibende Resonator mit einer Zwischenfrequenz ein Last-Q' aufweist, das in etwa das gleiche oder kleiner als das in etwa gleiche Last-Q ist.

6. Parallel geschaltetes mehrstufiges Bandpaßfilter nach Anspruch 5,
bei dem das Last-Q für jeden der Resonatoren so eingestellt ist, daß das Ausmaß der Änderung der Übertragungsfunktion in positiver Richtung des Bandpaßfilters innerhalb des bestimmten Durchlaßbandbereiches klein wird, wenn ein Nicht-Last-Q für jeden der Resonatoren endlich ist.

7. Parallel geschaltetes mehrstufiges Bandpaßfilter nach Anspruch 5,
bei dem das Last-Q für jeden der Resonatoren so gesetzt ist, daß jeweilige Änderungsausmaße an einer Mehrzahl Änderungspunkte, die in der Frequenzcharakteristik der Gruppenverzögerungszeit innerhalb eines vorgegebenen Banddurchlaßbereiches des Bandpaßfilters erzeugt werden, zueinander in etwa gleich sind.

8. Parallel geschaltetes mehrstufiges Bandpaßfilter nach Anspruch 5, bei dem das Last-Q für jeden der Resonatoren so gesetzt ist, daß die jeweiligen Änderungsausmaße an einer Mehrzahl Änderungspunkte, die in der Frequenzcharakteristik der Gruppenverzögerungszeit innerhalb eines vorgegebenen Banddurchlaßbereiches des Bandpaßfilters erzeugt werden, in etwa gleich Null sind.

9. Parallel geschaltetes mehrstufiges Bandpaßfilter nach einem der Ansprüche 1 bis 8,
bei dem die Phasen in den jeweiligen Resonanzfrequenzen der jeweiligen Signale, die durch Resonatoren mit benachbarten Resonanzfrequenzen hindurchgelangen, zueinander invertiert sind.

## Revendications

1. Filtre passe-bande à multiples étages à connexion parallèle comprenant :
une borne d'entrée (24, T₁) et une borne de sortie (25, T₂) pour des signaux ; et
une pluralité de résonateurs (21, 22, 23, 24) dont chacun est muni de premier et second ports et présentant des fréquences de résonance différentes les unes des autres et proches les unes des autres, un résonateur (21, 22, 23, 34) étant prévu pour chaque voie parallèle du filtre passe-bande,
caractérisé par :
des premier et second moyens d'adaptation d'impédance connectant chaque résonateur (21, 22, 23, 34) avec respectivement ladite borne d'entrée (24, T₁) et ladite borne de sortie (25, T₂) ;
ledit premier port de chacun desdits résonateurs étant connecté électriquement à ladite borne d'entrée par l'intermédiaire dudit premier moyen d'adaptation d'impédance au moyen d'un couplage inductif ou capacitif, ledit second port de chacun desdits résonateurs étant connecté électriquement à ladite borne de sortie (25) par l'intermédiaire dudit second moyen d'adaptation d'impédance au moyen du même type de couplage que pour le premier moyen d'adaptation d'impédance ; et
ledit filtre passe-bande comprenant en outre un moyen de blindage (33) pour empêcher un couplage entre ladite pluralité de résonateurs (21, 22, 23, 34).

2. Filtre passe-bande à multiples étages à connexion parallèle selon la revendication 1, dans lequel les résonateurs respectifs sont des résonateurs diélectriques.

3. Filtre passe-bande à multiples étages à connexion parallèle selon l'une quelconque des revendications 1 et 2, dans lequel les résonateurs respectifs sont des résonateurs du type ligne de transmission.

4. Filtre passe-bande à multiples étages à connexion parallèle selon la revendication 3, dans lequel lesdits résonateurs du type ligne de transmission sont des résonateurs diélectriques coaxiaux ou des lignes micro-bandes.

5. Filtre passe-bande à multiples étages à connexion parallèle selon l'une quelconque des revendications 1 à 4, dans lequel trois résonateurs sont prévus et dans lequel, dans lesdits résonateurs respectifs, les résonateurs présentant respectivement les fréquences de résonance maximum et minimum présentent approximativement le même Q de charge de telle sorte que le résonateur restant présentant une fréquence intermédiaire présente un Q de charge Q' qui est approximativement le même que ledit approximativement même Q de charge ou qui est inférieur à celui-ci.

6. Filtre passe-bande à multiples étages à connexion parallèle selon la revendication 5, dans lequel le Q de charge de chacun desdits résonateurs est établi de telle sorte que la valeur de variation d'une fonction de transfert de direction positive dudit filtre passe-bande dans une région de bande passante prédéterminée devienne faible lorsqu'un Q de non charge de chacun desdits résonateurs est fini.

7. Filtre passe-bande à multiples étages à connexion parallèle selon la revendication 5, dans lequel le Q de charge de chacun desdits résonateurs est établi de telle sorte que des valeurs respectives de variation au niveau d'une pluralité de points de variation à produire dans la caractéristique de fréquence d'un temps de retard de groupe dans une région de bande passante prédéterminée dudit filtre passe-bande deviennent approximativement égales les unes aux autres.

8. Filtre passe-bande à multiples étages à connexion parallèle selon la revendication 5, dans lequel le Q de charge de chacun desdits résonateurs est établi de telle sorte que des valeurs respectives de variation au niveau d'une pluralité de points de variation à produire dans la caractéristique de fréquence d'un temps de retard de groupe dans une région de bande passante prédéterminée dudit filtre passe-bande deviennent approximativement égales à zéro.

9. Filtre passe-bande à multiples étages à connexion parallèle selon l'une quelconque des revendications 1 à 8, dans lequel des phases dans les fréquences de résonance respectives des signaux respectifs traversant les résonateurs présentant des fréquences de résonance voisines sont inversées les unes par rapport aux autres.
